Europäisches Patentamt

European Patent Office

Office européen des brevets

(19)

(11) Veröffentlichungsnummer : **0 414 657 B1**

(12)
# EUROPÄISCHE PATENTSCHRIFT

(45) Veröffentlichungstag der Patentschrift :
**06.04.94 Patentblatt 94/14**

(21) Anmeldenummer : **90890237.2**

(22) Anmeldetag : **09.08.90**

(51) Int. Cl.⁵ : **H02H 7/22,** H01H 1/00,
G01R 31/32

(54) Elektronische Einrichtung zur Erfassung und Speicherung in einem Leistungsschalter ausgeschalteter Kurzschlussströme.

(30) Priorität : **23.08.89 AT 1991/89**

(43) Veröffentlichungstag der Anmeldung :
**27.02.91 Patentblatt 91/09**

(45) Bekanntmachung des Hinweises auf die
Patenterteilung :
**06.04.94 Patentblatt 94/14**

(84) Benannte Vertragsstaaten :
**BE CH DE ES FR GB GR IT LI LU NL SE**

(56) Entgegenhaltungen :
EP-A- 0 258 090
DD-A- 2 006 998
DE-A- 2 727 378
DE-U- 8 504 729
SE-B- 445 274

(73) Patentinhaber : **Sprecher Energie Österreich
Gesellschaft m.b.H.
Franckstrasse 51
A-4020 Linz (AT)**

(72) Erfinder : **Höfer, Hermann, Ing.
Häusererweg 3
A-4020 Linz/Puchenau (AT)**

(74) Vertreter : **Rossboth, Werner Heinz
c/o Sprecher Energie Österreich Gesellschaft
m.b.H. Franckstrasse 51
A-4020 Linz (AT)**

## Beschreibung

Die Erfindung bezieht sich auf eine elektronische Einrichtung zur Erfassung und Speicherung in einem Leistungsschalter ausgeschalteter Kurzschlußströme mit einem Stromwandler sowie einem in den Schutzkreis dieses Stromwandlers geschalteten Nebenschlußwiderstand mit antiparallel geschalteten Dioden zur Spannungsbegrenzung und einer Steckeinheit, deren steckbarer Teil einen als Trenntransformator ausgeführten Spannungsübertrager mit sekundärseitig parallelgeschaltetem Stufenwiderstand und eine Auswertelogik zur Verarbeitung der stromäquivalenten Spannungssignale aus dem Nebenschlußwiderstand umfaßt.

Aus der DE-OS 2 727 378 ist eine Einrichtung zur Kontrolle der Betriebsfähigkeit von Schaltgeräten mit einem Stromwandler bekannt, der mit einer Bürde belastet ist. Zur Ermittlung und Summierung der Abbrandwerte der Kontakte des Schaltgerätes wird die an einem Ausgang der Bürde zur Verfügung stehende, dem Ausschaltstrom proportionale Spannung herangezogen. Nachteilig ist bei dieser Einrichtung einerseits, daß die elektronischen Komponenten im Kurzschlußfall durch hohe induzierte Spannungen bzw. übertragene Ströme im Sekundärkreis des Stromwandlers gefährdet sind, anderseits bei hohen Kurzschlußströmen der Stromwandler rasch in Sättigung gelangt und verfälschte Stromwerte liefert.

Die Gefahr der transienten Wandlersättigung ist besonders bei Kurzschlüssen in der Nähe von Hochspannungs-Schaltanlagen groß. Wegen des hohen Gesamtkurzschlußstromes und der großen Zeitkonstanten des Gleichstromgliedes ist die Sättigung der Stromwandler im fehlerbehafteten Abzweig unvermeidbar. Für den Sammelschienenschutz bedeutet das die Möglichkeit einer Fehlauslösung bei äußeren Fehlern. Umfangreiche Messungen haben ergeben, daß in extrem ungünstigen Fällen die Wandlersättigung bereits einige Millisekunden nach Kurzschlußbeginn eintritt.

Man konnte diesem Problem nur durch Verwendung überdimensionierter Stromwandler mit Linearkernen oder den Einsatz ultraschneller Schutzeinrichtungen begegnen, welche beispielsweise durch die Auswertung von transienten Differenz-Signalen für Spannung und Strom in der sehr kurzen Zeit zwischen Kurzschlußbeginn und Stromwandlersättigung Kurzschlußfehler erkennen und lokalisieren können.

In der DD-PS 200 699 wird eine Schaltungsanordnung zur Ermittlung des Löschmittelverschleisses bei Hochspannungsschaltern beschrieben, die aus einem Stromwandler mit Bürde und Gleichrichter, einer elektronischen Meßwertauswerteeinheit und einem im Hochspannungsschalter angeordneten UV-sensiblen Bauelement besteht. Zur Erfassung der Lichtbogendauer bei einem Schaltspiel des Hochspannungsschalters muß das UV-sensible Bauelement bzw. die Photodiode in der Nähe der Lichtbogenkontakte angeordnet sein. Dies stellt jedoch eine relativ aufwendige Maßnahme und ein technisches Problem dar, weil durch die Zuleitungen zur Photodiode keine Verschlechterung der dielektrischen Eigenschaften des Hochspannungsschalters eintreten darf. Außerdem werden bei dieser Schaltungsanordnung nicht nur Ausschalt-Lichtbögen, sondern auch durch Vorzündung entstehende Einschalt-Lichtbögen erfaßt, welche jedoch als Maß für den Abbrand der Schaltkontakte bedeutungslos sind, ebenso wie die schwachen Ausschalt-Lichtbögen normaler Betriebsströme. Die elektronische Meßwertauswerteeinheit wird dabei erst aktiviert, wenn im Hochspannungsschalter ein Lichtbogen gezündet wird.

Zwischen Beginn des Kurzschlusses und der Lichtbogenzündung im Hochspannungsschalter liegt jedoch die Relaiszeit der Schutzeinrichtungen und die Ausschalteigenzeit des Hochspannungsschalters. Zum Zeitpunkt der Lichtbogenzündung können daher nur Halbwellen des Kurzschlußstromes erfaßt werden, die vom Stromwandler infolge seiner Sättigung verzerrt übertragen wurden und daher verfälschte Werte ergeben.

Durch die in der Folge aufgezeigte erfindungsgemäße Ausführung wird bezweckt, eine elektronische Einrichtung der eigangs genannten Art zu schaffen, welche als handelsübliche Steckeinheit ohne verstärkte Steckkontakte ausführbar ist und eine zuverlässige Erfassung und Speicherung der in einem Leistungsschalter ausgeschalteten Kurzschlußströme erlaubt, auch wenn der Stromwandler in Sättigung gelangt.

Diese wird dadurch erreicht, daß an einen ersten Eingang der Auswertelogik über an sich bekannte Optokoppler ein Ausschaltbefehl-Meldekreis des Leistungsschalters und an einen zweiten Eingang ein an sich bekannter Analog-Digital-Wandler mit vorgeschaltetem Vollweg-Gleichrichter, der an den Stufenwiderstand geschaltet ist, angeschlossen ist, die Auswertelogik eine Speichereinheit enthält und das einem Stoßkurzschlußstrom äquivalente Spannungssignal erfaßt und, soferne der Leistungsschalter einen Ausschaltbefehl erhält, in Abhängigkeit von der Netzzeitkonstante und der zwischen Kurzschlußbeginn und Lichtbogenlöschung im Leistungsschalter verstrichenen Zeit auf einen dem Effektivwert des Kurzschlußausschaltstromes äquivalenten Wert umwandelt und in der Speichereinheit aufsummiert.

Entsteht beispielsweise in der Nähe von Schaltanlagen ein Kurzschluß zwischen den Phasen eines Wechselstromnetzes, tritt ein hoher Kurzschlußstrom auf, der auch durch die Primärwicklungen der in der Schaltanlage zu Meß-und Schutzzwecken vorhandenen Stromwandler fließt. Die Stromwandlerkerne sind normalerweise für eine lineare Stromübertragung von höchstens zweifachem Nennstrom ausgelegt und gelangen daher rasch in ihren Sättigungsbereich, in dem sie nur mehr verfälschte Werte liefern. Messungen haben ergeben, daß jedoch die erste Halbwelle des Kurzschlußwechselstromes, d.h. der Stoßkurzschlußstrom, noch ausreichend linear übertragen wird. Durch die erfindungsgemäße elektronische Einrichtung kann daher ein dem Stoßkurzschlußstrom äquivalentes Spannungssignal erfaßt und ausgewertet werden. Um eine für den Abbrand der Schaltstücke eines Leistungsschalters maßgebende Stromsumme zu erhalten, muß jedoch das dem Scheitelwert des Stoßkurzschlußstromes äquivalente Signal noch auf ein dem Effektivwert des tatsächlichen Kurzschlußausschaltstromes äquivalentes Signal reduziert werden. Bekanntlich wird der zeitliche Verlauf des Kurzschlußstromes bei einem Netzkurzschluß von der Zeitkonstante des Gleichstromgliedes bestimmt, wobei diese Zeitkonstante von den Netzimpedanzen und den wirksamen Impedanzen der Ge-neratoren beeinflußt wird. Die Zeitkonstanten bestehender Netze sind bekannt, so daß bei Erfassung der Effektivwert des ausgeschalteten Kurzschlußstromes errechenbar ist.

Für diese Umrechnung kann in der Auswertelogik ein Algorithmus oder eine Tabelle enthalten bzw. gespeichert sein.

Damit in der Auswertelogik nur vom Leistungsschalter auszuschaltende Kurzschlußströme umgewandelt und aufsummiert werden, ist an einen ersten Eingang der Auswertelogik über Optokoppler ein Ausschaltbefehl-Meldekreis angeschlossen. Über einen zweiten Eingang erhält die Auswertelogik von einem Analog-Digital-Wandler mit vorgeschaltetem Vollweg-Gleichrichter stromäquivalente Spannungssignale.

Der Auswertelogik kann ein Vergleicher vorgeschaltet sein, der die stromäquivalenten Spannungssignale mit einem voreingestellten konstanten Schwellwert vergleicht und an die Auswertelogik ein Signal überträgt, sobald dieser Schwellwert überschritten wird.

Damit ist die Auswertelogik aktiviert, wenn ein Kurzschlußstrom durch die Primärwicklung des Stromwandlers fließt und die Erfassung der ersten Halbwelle des Kurzschlußwechselstromes möglich.

Die Auswertelogik kann auch mit einem Spannungskomparator, beispielsweise Schmitt-Trigger, zur Digitalisierung der stromäquivalenten Spannungssignale elektrisch verbunden sein und mittels der aus dem Spannungskomparator kommenden digitalen Signale die Spannungs-Nulldurchgänge des Spannungsübertragers von Kurzschlußbeginn an zählen und auswerten.

Wenn auch vom Stromwandler im Kurzschlußfall nur mehr verfälschte Strom- bzw. Spannungswerte übertragen werden, genügen diese verzerrten Halbwellen zur Erfassung der Nulldurchgänge im Spannungskomparator. Bei bekannter Netzfrequenz ist dadurch die Zeit zwischen Kurzschlußbeginn und Löschung des Kurzschlußstromes festgehalten. Ermittelbar ist aber auch die Lichtbogenzeit des Leistungsschalters, weil Relaiszeit und Ausschalteigenzeit des Leistungsschalters bekannt sind.

Bevorzugterweise ermittelt die Auswertelogik die Lichtbogenzeit aus der Differenz zwischen Signal aus dem Ausschaltbefehl-Meldekreis und Lichtbogenlöschung im Leistungsschalter sowie bekannter Relaiszeit und Ausschalteigenzeit des Leistungsschalters und speichert diese in ihrer Speichereinheit.

Effektivwert des Kurzschlußausschaltstromes und zugehörige Lichtbogenzeit ergeben ein genaues Kriterium für den Abbrand der Kontaktstücke des Leistungsschalters.

Die Auswertelogik kann über einen Ausgang das Relais eines Meldekreises aktivieren, wenn die in ihrer Speichereinheit gespeicherte Stromsumme oder das gespeicherte Produkt aus Stromsumme und Lichtbogenzeiten einen vorbestimmten Wert überschreitet. Über diesen Meldekreis kann dadurch eine fällig gewordene Kontaktrevision des Leistungsschalters in der Leitstation der Schaltanlage angezeigt werden.

Um die Einrichtung an Leistungsschalter mit verschiedenen Ausschaltzeiten und die Nennströme der Stromwandler angleichen zu können, ist die in der Auswertelogik auszuwertende Zahl von Spannungs-Nulldurchgängen sowie der konstante Schwellwert des Vergleichers mittels dekadischer Ziffernschalter setzbar.

Obwohl die Auswertelogik auch aus handelsüblichen integrierten Schaltkreisen zu realisieren ist, besteht sie bevorzugterweise aus einem Mikroprozessor mit Zeiteinheit und Ringpuffer.

Im Ringpuffer bleiben die aktuellen stromäquivalenten Spannungssignale aus dem Analog-Digital-Wandler stets gespeichert und können, wenn der Leistungsschalter einen Ausschaltbefehl erhält, in Signale für den Effektivwert des Kurzschlußausschaltstromes und, die Lichtbogenzeit umgewandelt und in der Speichereinheit aufsummiert werden.

Vergleicher und Spannungskomparator werden dadurch überflüssig. Bei Verwendung eines Mikroprozessors ist außerdem die Möglichkeit einer Echtzeiterfassung, Protokollierung und Aufzeichnung der Ausschaltvorgänge durch Angabe der aufsummierten Effektivwerte des Kurzschlußausschaltstromes und zugehörigen Lichtbogenzeiten des Leistungsschalters gegeben.

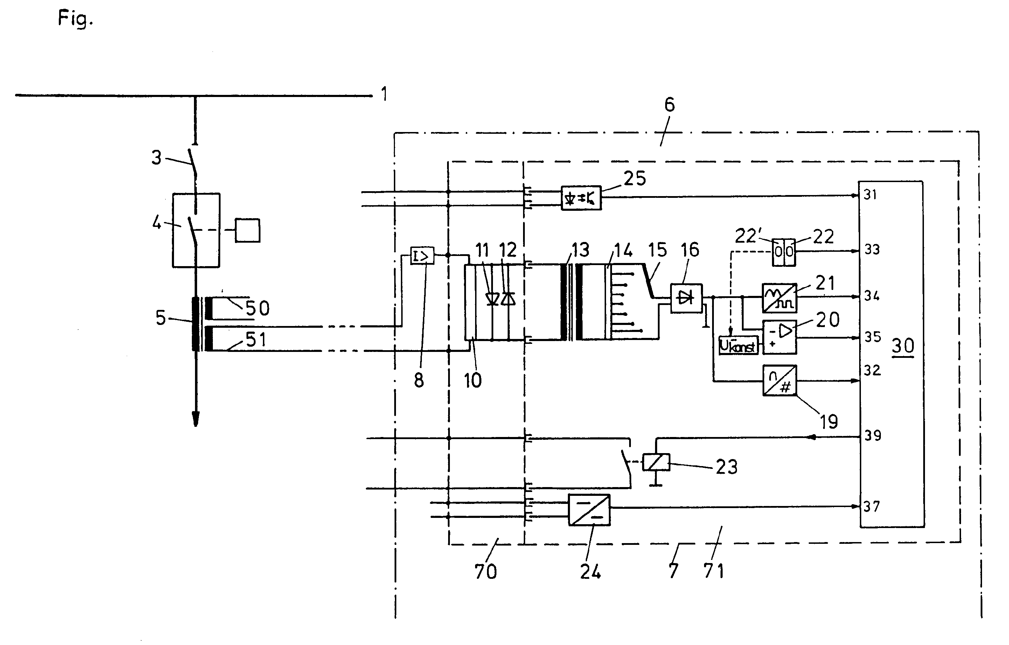

Im folgenden wird an Hand der beiliegenden Zeichnung ein Ausführungsbeispiel des Erfindungsgegenstandes näher erläutert. Es zeigt die einzige Fig. das schematische Blockschaltbild einer erfindungsgemäßen elektronischen Einrichtung. Aus der Fig. ist die an Wechselspannung liegende Sammelschiene 1 einer Hochspannungsschaltanlage ersichtlich. Von dieser Sammelschiene 1 führen Abgänge zu Verbrauchern. In der Fig. ist nur ein Abgang mit einem Trennschalter 3, Leistungsschalter 4 und Stromwandler 5 dargestellt. Dieser Stromwandler 5 besitzt zwei Kerne mit Sekundärkreisen 50, 51, einen Meßkreis 50 zur Strommessung sowie -zählung und einen Schutzkreis 51, in den ein Überstromrelais 8 geschaltet ist, welches beispielsweise einen Verbraucher vor Überlast bzw. unzulässig hohe Erwärmung schützt und im Überlastfall die Schutzauslösung des Leistungsschalters 4 aktiviert. Die Stromwandlerkerne sind für eine lineare Stromübertragung bis zum 1,2-fachen Nennstrom gemäß dem Normalbereich der Wandlerbestimmungen ausgelegt. Zur Erfassung der vom Leistungsschalter 4 ausgeschalteten Kurzschlußströme befinden sich in einem Steuerschrank 6, der in der Fig. mit strichpunktierten Linien schematisch dargestellt ist, neben dem Überstromrelais 8 auch die als Steckeinheit 7 ausgebildete erfindungsgemäße elektronische Einrichtung. Die Steckeinheit 7 besteht aus dem im Steuerschrank 6 festmontierten und verdrahteten Teil 70 und dem als Steckkarte ausgeführten Teil 71 und ist in der Fig. strichliert gezeichnet.

Auf dem festmontierten Teil 70 ist ein in den Schutzkreis 51 des Stromwandlers 5 geschalteter Nebenschlußwiderstand 10 angeordnet, dem zur Steckkarte hin zwei Dioden 11, 12 zur Spannungsbegrenzung antiparallel geschaltet sind.

Der steckbare Teil 71 der Steckeinheit 7 trägt eine Auswertelogik 30 mit Speichereinheit, an deren ersten Eingang 31 über Optokoppler 25 ein Ausschaltbefehl-Meldekreis des Leistungsschalters 4 angeschlossen ist, damit die Auswertelogik 30 ein Signal erhält, wenn ein Ausschaltvorgang eingeleitet wurde. Mit dem zweiten Eingang 32 der Auswertelogik 30 ist ein AnalogDigital-Wandler 19 mit vorgeschaltetem Vollweg-Gleichrichter 16 elektrisch leitend verbunden. Über den Eingang 37, der mit einem Versorgungskreis, beispielsweise einem Gleichspannungswandler 24, elektrisch verbunden ist, erhält die Auswertelogik 30 benötigte elektrische Energie.

Der Nebenschlußwiderstand 10 mit seinen antiparallel geschalteten Dioden 11, 12 ist über einen als Trenntransformator ausgeführten Spannungsübertrager 13 mit sekundärseitig parallelgeschaltetem Stufenwiderstand 14 mit Stufenschalter 15, Vollweg-Gleichrichter 16, Spannungskomparator 21 und parallelgeschaltetem Vergleicher 20 an die Eingänge 34, 35 der Auswertelogik 30 angeschlossen.

Parallel zum Spannungskomparator 21, beispielsweise zu einem SchmittTrigger, und Vergleicher 20 liegt auch der Analog-Digital-Wandler 19.

Der einzige Ausgang 39 der Auswertelogik 30 ist mit einem Relais 23 elektrisch verbunden, welches einen Meldekreis in die Leitwarte der Hochspannungsschaltanlage schließen kann.

Tritt nun in oder in der Nähe der Hochspannungsschaltanlage ein Kurzschluß auf, wird die Primärwicklung des Stromwandlers 5 von einem hohen Kurzschlußwechselstrom durchflossen. Bevor die Stromwandlerkerne in ihren Sättigungsbereich gelangen, wird vom Stromwandler 5 die erste Halbwelle des Kurzschlußwechselstromes, d.h. der Stoßkurzschlußstrom, linear in die Sekundärkreise übertragen. Die am Nebenschlußwiderstand 10 auftretende stromäquivalente Spannungsabfallspitze gelangt über den Spannungsübertrager 13 mit sekundärseitig parallelgeschaltetem Stufenwiderstand 14 zum Vollweg-Gleichrichter 16, wird in ein positives Spannungssignal umgewandelt und im AnalogDigital-Wandler 19 in einen digitalen Stromscheitelwert umgesetzt. Gleichzeitig werden die aus dem Vollweg-Gleichrichter 16 kommenden Halbwellen im Spannungskomparator 21 regeneriert und in digitale Signale mit steilen Flanken umgeformt. Obwohl die Stromwandlerkerne nach der ersten Halbwelle des Kurzschlußwechselstromes in ihren Sättigungsbereich gelangt sind und nur mehr verzerrte Halbwellen übertragen, erkennt und zählt die Auswertelogik 30 auf Grund dieser digitalen Signale exakt die Spannungs-Nulldurchgänge der Wechselspannung am Stufenwiderstand 14.

Die Zahl der Spannungs-Nulldurchgänge, innerhalb welche die Auswertelogik 30 aktiviert bleiben soll, ist über den dekadischen Ziffernschalter 22 eingebbar, wobei die Relaiszeit, Ausschalt-Eigenzeit und Lichtbogenzeit des Leistungsschalters 4 zu berücksichtigen sind. Über den dekadischen Ziffernschalter 22' ist der im Vergleicher 20 vorgewählte konstante Schwellwert setzbar. Dieser Schwellwert beträgt beispielsweise das dem dreifachen Stromwandler-Sekundärstrom entsprechende Spannungssignal. Fließt nun ein Kurzschlußstrom durch die Primärwicklung des Stromwandlers 5, wird dieser Schwellwert überschritten und die Auswertelogik 30 erhält vom Vergleicher 20 ein Aktivierungssignal. Die Auswertelogik 30 erfaßt den aus dem Analog-Digital-Wandler 19 kommenden digitalen Stromscheitelwert und bleibt solange aktiviert, bis die im dekadischen Ziffernschalter 22 gesetzte Zahl der Spannungs-Nulldurchgänge erreicht ist. Erhält die Auswertelogik 30 innerhalb dieser Zeitspanne über den Optokoppler 25 ein Signal vom Ausschaltbefehl-Meldekreis des Leistungsschalters 4, wird der erfaßte digitale Stromscheitelwert mittels programmierter Algorithmen in einen Wert umgewandelt, der dem Effektivwert des vom Leistungsschalter 4 ausgeschalteten Kurzschlußstromes entspricht. Aus der Zahl der ermittelten Spannungs-Nulldurchgänge wird von der Auswertelogik 30 außerdem die Zeit zwischen Kurzschlußbeginn und Lichtbogenlöschung im Leistungsschalter 4 mit Hilfe der Netzfrequenz festgehalten.

Der Effektivwert des Kurzschlußausschaltstromes ist gemäß dem zeitlichen Verlauf des Kurzschlußstromes bei einem Netzkurzschluß nach folgenden Formeln errechenbar:

$$I_K = \frac{I_S}{2 \cdot \sqrt{3}}$$

$I_S$ = Stoßkurzschlußstrom (Scheitelwert)
$I_K$ = Effektivwert des Kurzschlußstromes

$$a = 100 \, (e^{\frac{-T}{Td}})$$

a = Gleichstromkomponente in Prozent
T = Zeit vom Beginn des Kurzschlusses bis zur Lichtbogenlöschung
Td = Zeitkonstante des Netzes

$$I_{KA} = \frac{I_K}{\sqrt{1 + (\frac{a}{100} \cdot \sqrt{2})^2}}$$

IKA = Effektivwert des Kurzschlußausschaltstromes

Liegt die Zahl der ermittelten Spannungs-Nulldurchgänge unter der im dekadischen Ziffernschalter 22' gesetzten Zahl wird von der Auswertelogik 30 der erfaßte und umgewandelte digitale Stromscheitelwert in ihrer Speichereinheit aufsummiert.

Bei der Ermittlung der Zeit zwischen Kurzschlußbeginn und Lichtbogenlöschung kann durch eine Konstante die unterschiedliche Lichtbogenzeit des Leistungsschalters 4 innerhalb einer Halbperiode des Kurzschlußstromes berücksichtigt sein.

Um ein noch genaueres Kriterium als die Stromsumme für den Abbrand der Kontaktstücke des Leistungsschalters 4 zu erhalten, kann die Auswertelogik 30 so programmiert sein, daß sie zum jeweiligen Effektivwert des Kurzschlußausschaltstromes die zugehörige Lichtbogenzeit des Leistungsschalters 4 ermittelt und speichert.

Diese Lichtbogenzeit ergibt sich aus der Differenz zwischen Signal aus dem Ausschaltbefehl-Meldekreis und Lichtbogenlöschung sowie bekannter Relaiszeit und Ausschalt-Eigenzeit des Leistungsschalters 4. Wird die im dekadischen Ziffernschalter 22 gesetzte Zahl der Spannungs-Nulldurchgänge überschritten und hat die Auswertelogik 30 kein Signal vom AusschaltbefehlMeldekreis erhalten, fällt sie in ihre Ausgangslage zurück.

Soferne in der Speichereinheit der Auswertelogik 30 ein gesetzter Stromsummenwert oder gesetztes Produkt aus Stromsumme und ermittelten Lichtbogenzeiten überschritten wird, kommt es zur Aktivierung des Meldekreises über den Ausgang 39, wodurch in der Leitwarte der Hochspannungsschaltanlage die fällige Kontaktrevision des Leistungsschalters 4 angezeigt wird.

Zur Vereinfachung der Schaltung kann die Auswertelogik 30 aus einem Mikroprozessor mit Zeiteinheit und Ringpuffer bestehen. In diesem Ringpuffer können die stromäquivalenten digitalen Spannungssignale aus dem Analog-Digital-Wandler 19 zeitbezogen laufend erfaßt und gespeichert werden. Reicht das vorhandene Speichervermögen des Ringpuffers nicht mehr aus, werden die ältesten Signale gelöscht und überschrieben. Die aktuellen digitalen Spannungssignale sind daher immer verfügbar. Erhält der Mikroprozessor über den Eingang 31 ein Signal aus dem Ausschaltbefehl-Meldekreis des Leistungsschalter 4 wandelt er das größte, im Ringpuffer gespeicherte stromäquivalente Spannungssignal mit Hilfe von Algorithmen in den Effektivwert des Kurzschlußausschaltstromes um und ermittelt die Lichtbogenzeit aus der Zeitdifferenz zwischen größtem Spannungssignal und letztem Spannungssignal sowie Signal aus dem Ausschaltbefehl-Meldekreis und letztem Spannungssignal vor der Lichtbogenlöschung. Beide Werte werden in der Speichereinheit aufsummiert.

Der Mikroprozessor kann zusätzliche Ausgänge besitzen, über welche beispielsweise die Protokollierung der aufsummierten Stromwerte und zugehörigen Lichtbogenzeiten bzw. gebildeten Produkte aus Stromwert und Lichtbogenzeit möglich wird. Soferne in der Speichereinheit ein Kalender gespeichert ist, sind auch Tageszeitangaben zu den einzelnen gespeicherten Werten realisierbar.

**Patentansprüche**

1. Elektronische Einrichtung zur Erfassung und Speicherung in einem Leistungsschalter (4) ausgeschalteter Kurzschlußströme mit einem Stromwandler (5) sowie einem in den Schutzkreis dieses Stromwandlers geschalteten Nebenschlußwiderstand (10) mit antiparallel geschalteten Dioden (11,12) zur Spannungsbegrenzung und einer Steckeinheit (7), deren steckbarer Teil (71) einen als Trenntransformator ausgeführten Spannungsübertrager (13) mit sekundärseitig parallelgeschaltetem Stufenwiderstand (14,15) und eine Auswertelogik (30) zur Verarbeitung der stromäquivalenten Spannungssignale aus dem Nebenschlußwiderstand (10) umfaßt, dadurch gekennzeichnet, daß an einen ersten Eingang (31) der Auswertelogik (30) über an sich bekannte Optokoppler (25) ein Ausschaltbefehl-Meldekreis des Leistungsschalters (4) und an einen zweiten Eingang (32) ein an sich bekannter Analog-Digital-Wandler (19) mit vom geschaltetem Vollweg-Gleichrichter (16), der an den Stufenwiderstand (14,15) geschaltet ist, angeschlossen ist, die Auswertelogik (30) eine Speichereinheit enthält und das einem Stoßkurzschlußstrom äquivalente Spannungssignal erfaßt und, soferne der Leistungsschalter (4) einen Ausschaltbefehl erhält, in Abhängigkeit von der Netzzeitkonstante und der zwischen Kurzschlußbeginn und Lichtbogenlöschung im Leistungsschalter (4) verstrichenen Zeit auf einen dem Effektivwert des Kurzschlußausschaltstromes äquivalenten Wert umwandelt und in der Speichereinheit aufsummiert.

2. Elektronische Einrichtung nach Anspruch 1, dadurch gekennzeichnet, daß der Auswertelogik (30) ein Vergleicher (20) vorgeschaltet ist, der die stromäquivalenten Spannungssignale mit einem voreingestellten konstanten Schwellwert vergleicht und an die Auswertelogik (30) ein Signal überträgt, sobald dieser Schwellwert überschritten wird.

3. Elektronische Einrichtung nach Anspruch 1 oder 2, dadurch gekennzeichnet, daß die Auswertelogik (30) mit einem Spannungskomparator (21), beispielsweise Schmitt-Trigger, zur Digitalisierung der stromäquivalenten Spannungssignale elektrisch verbunden ist und mittels der aus dem Spannungskomparator (21) kommenden digitalen Signale die Spannungs-Nulldurchgänge des Spannungsübertragers (13) von Kurzschlußbeginn an zählt und auswertet.

4. Elektronische Einrichtung nach einem der Ansprüche 1 bis 3, dadurch gekennzeichnet, daß die Auswertelogik (30) die Lichtbogenzeit aus der Differenz zwischen Signal aus dem Ausschaltbefehl-Meldekreis und Lichtbogenlöschung im Leistungsschalter (4) sowie bekannter Relaiszeit und Ausschalt-Eigenzeit des Leistungsschalters (4) ermittelt und in der Speichereinheit speichert.

5. Elektronische Einrichtung nach einem der Ansprüche 1 bis 4, dadurch gekennzeichnet, daß die Auswertelogik (30) über einen Ausgang (39) das Relais (23) eines Meldekreises aktiviert, wenn die in ihrer Speichereinheit gespeicherte Stromsumme oder gespeichertes Produkt aus Stromsumme und Lichtbogenzeiten einen vorbestimmten Wert überschreitet.

6. Elektronische Einrichtung nach einem der Ansprüche 1 bis 5, dadurch gekennzeichnet, daß die in der Auswertelogik (30) auszuwertende Zahl von Spannungs-Nulldurchgängen sowie der konstante Schwellwert des Vergleichers (20) mittels dekadischer Ziffernschalter (22, 22') setzbar ist.

7. Elektronische Einrichtung nach einem der Ansprüche 1 bis 6, dadurch gekennzeichnet, daß die Auswertelogik (30) aus einem Mikroprozessor mit Zeiteinheit und Ringpuffer besteht.

8. Elektronische Einrichtung nach Anspruch 7, dadurch gekennzeichnet, daß die Auswertelogik (30) zusätzliche Ausgänge zur Protokollierung der aufsummierten Effektivwerte des Kurzschlußausschaltstromes und zugehörigen Lichtbogenzeiten des Leistungsschalters (4) aufweist.

**Claims**

1. Electronic device for detecting and storing short-circuit currents, broken in a circuit breaker (4), comprising a current transformer (5) and a shunt resistor (10), connected into the protective circuit of this current transformer, with antiparallel-connected diodes (11, 12) for voltage limiting, and a plug-in unit (7), the pluggable part (71) of which comprises a voltage transformer (13), constructed as isolating transformer, with tapped resistor (14, 15) connected in parallel with its secondary side, and an evaluating logic (30) for processing the current-equivalent voltage signals from the shunt resistor (10), characterized in that a breaking command signalling circuit of the circuit breaker (4) is connected to a first input (31) of the evaluating logic (30) via optocouplers (25), known per se, and an analog/-digital converter (19) known per se, preceded by a fullwave rectifier (16), which is connected to the tapped resistor (14, 15), is connected to a second input (32), the evaluating logic (30) contains a memory unit and detects the voltage signal equivalent to a short-circuit surge current and, if the circuit breaker (4) receives a breaking command, converts this voltage signal to a value equivalent to the rms value of the short-circuit breaking current in dependence on the power-system time constant and the time elapsed between the beginning of the short-circuit and quenching of the arc in the circuit breaker (4), and accumulates this value in the memory unit.

2. Electronic device according to Claim 1, characterized in that the evaluating logic (30) is preceded by a comparator (20) which compares the current-euqivalent voltage signals with a preset constant threshold value and transfers a signal to the evaluating logic (30) as soon as this threshold value is exceeded.

3. Electronic device according to Claim 1 or 2, characterized in that the evaluating logic (30) is electrically connected to a voltage comparator (21), for example a Schmitt trigger, for digitizing the current-equivalent voltage signals and counts and evaluates the voltage zero crossings of the voltage transformer (13) from the beginning of the short-circuit by means of the digital signals coming from the voltage comparator (21).

4. Electronic device according to one of Claims 1 to 3, characterized in that the evaluating logic (30) determines, and stores in the memory unit, the arcing time from the difference between the signal from the breaking command signalling circuit and arc quenching in the circuit breaker (4) and the known relay time and inherent breaking time of the circuit breaker (4).

5. Electronic device according to one of Claims 1 to 4, characterized in that the evaluating logic (30) activates the relay (23) of a signalling circuit via an output (39) when the current sum stored in its memory unit or the stored product of current sum and arcing times exceeds a predetermined value.

6. Electronic device according to one of Claims 1 to 5, characterized in that the number of voltage zero crossings to be evaluated in the evaluating logic (30) and the constant threshold value of the comparator (20) can be set by means of decimal digit switches (22, 22').

7. Electronic device according to one of Claims 1 to 6, characterized in that the evaluating logic (30) consists of a mircoprocessor with timing unit and ring buffer.

8. Electronic device according to Claim 7, characterized in that the evaluating logic (30) has additional outputs for logging the aggregate rms values of the short-circuit breaking current and associated arcing times of the circuit breaker (4).


**Revendications**

1. Dispositif électronique pour saisir et mémoriser des courants de court-circuit coupés dans un disjoncteur de puissance (4), comportant un transformateur de courant (5) ainsi qu'une résistance shunt (10) mise dans le circuit de protection de ce transformateur de courant et comprenant des diodes (11, 12), montées en antiparallèle, pour limiter la tension, ainsi qu'un organe enfichable (7) dont la, partie enfichable (71) comprend un transformateur de tension (16) réalisé sous forme de transformateur de séparation avec une résistance à gradins (14, 15) montée en parallèle du côté du secondaire et un circuit logique de traitement (30) pour traiter les signaux de tension équivalents au courant provenant de la résistance shunt (10), dispositif caractérisé par le fait qu'à une première entrée (31) du circuit logique de traitement (30) est relié, par l'intermédiaire d'un coupleur optique (25), connu en soi, un circuit d'annonce de l'ordre de disjonction pour le disjoncteur de puissance (4) et, à une seconde entrée (32), est relié un convertisseur analogique-numérique (19), connu en soi, avec un redresseur pleine onde (16) monté en amont et relié à la résistance à gradins (14, 15), par le fait que le circuit logique de traitement (30) contient un organe de mémorisation et saisit le signal de tension équivalent à un courant de court-circuit brusque et, dans la mesure où le disjoncteur de puissance (4) reçoit un ordre de disjonction et en fonction de la constante de temps du réseau et du temps qui s'écoule entre le début du court-circuit et l'extinction de l'arc électrique dans le disjoncteur de puissance (4), convertit ce signal de tension en une valeur équivalente à la valeur effective du courant de disjonction du court-circuit et l'additionne dans l'organe de mémorisation.

**2.** Dispositif électronique selon la revendication 1, caractérisé par le fait qu'en amont du circuit logique de traitement (30) est monté un comparateur (20) qui compare les signaux de tension équivalents au courant avec une valeur de seuil constante prédéterminée et transmet un signal au circuit logique de traitement (30) dès que cette valeur de seuil est dépassée par valeur croissante.

**3.** Dispositif électronique selon la revendication 1 ou 2, caractérisé par le fait que le circuit logique de traitement (30) est relié avec un comparateur de tension (21), par exemple une bascule Schmitt, pour numériser les signaux de tension équivalents au courant et, au moyen des, signaux numériques provenant du comparateur de tension (21), compte les passages du transformateur de tension (13) par la valeur zéro de la tension à partir du début du court-circuit et traite ces signaux.

**4.** Dispositif électronique selon l'une des revendications 1 à 3, caractérisé par le fait que le circuit logique de traitement (30) détermine la durée de l'arc électrique à partir de la différence entre le signal provenant du circuit d'annonce de l'ordre de disjonction et l'extinction de l'arc électrique dans le disjoncteur de puissance (4) ainsi que de la constante de temps propre du relais, connue, et de la constante de temps propre de disjonction du disjoncteur de puissance (4), et mémorise cette durée dans l'organe de mémorisation.

**5.** Dispositif électronique selon l'une des revendications 1 à 4, caractérisé par le fait que le circuit logique de traitement (30), par l'intermédiaire d'une sortie (39), active le relais (23) d'un circuit d'annonce lorsque la somme des courants mémorisée dans son organe de mémorisation ou le produit, mémorisé, de la somme des courant et des durées de l'arc électrique, dépasse une valeur prédéterminée.

**6.** Dispositif électronique selon l'une des revendications 1 à 5, caractérisé par le fait que le nombre, à traiter dans le circuit logique de traitement (30), des passages par la valeur zéro de la tension, ainsi que la valeur de seuil constante du comparateur (20) peuvent être prescrits au moyen d'un commutateur numérique à décades (22, 22').

**7.** Dispositif électronique selon l'une des revendications 1 à 6, caractérisé par le fait que le circuit logique de traitement (30) est constitué d'un microprocesseur avec horloge et mémoire tampon annulaire.

**8.** Dispositif électronique selon la revendication 7, caractérisé par le fait que le circuit logique de traitement (30) présente des sorties supplémentaires pour l'enregistrement des valeurs effectives additionnées du courant de disjonction de court-circuit et des durées correspondantes de l'arc électrique du disjoncteur de puissance (4).

Fig.

6

EP 0 414 657 B1